# EUROPEAN PATENT APPLICATION

(11) **EP 2 320 454 A1**
(43) Date of publication of application: **11.05.2011**
(21) Application number: 09290838.3
(22) Date of filing: 05.11.2009
(51) Int. Cl.: H01L 21/687

(54) **Substrate holder and clipping device**

(71) Applicant: S.O.I.Tec Silicon on Insulator Technologies, 38926 Bernin (FR)
(72) Inventor: Besnard, Teddy, 38120 Saint-Egrève (FR)
(74) Representative: Grünecker, Kinkeldey, Stockmair & Schwanhäusser Anwaltssozietät

(57) **Abstract**

The invention relates to a substrate holder comprising a substrate support, a moveable clipping means configured to engage a substrate positioned on the support in a first position and to be positioned away from the substrate in a different position, a positioning means for moving the clipping means from the second position towards the first position. To prevent a contact between the clipping means and the support when no substrate is positioned on the support, an elastic stop element is used which limits the movement of the clipping means. The invention furthermore relates to a clipping device and an ion implanter using the substrate holder and the clipping device.

## Description

The invention relates to a substrate holder and a clipping device for releasably keeping a substrate on a substrate holder. Such a substrate holder and/or clipping device is, for instance, used in an ion implanting device.

Ion implanters, for example a Quantum Implanter of Applied Materials, are used to implant ions into semiconductor substrates. For example, hydrogen and/or helium ions are implanted into silicon wafers of 200 or 300 mm in diameter in the so-called Smart Cut™ process used to fabricate semiconductor on insulator (SOI) substrates.

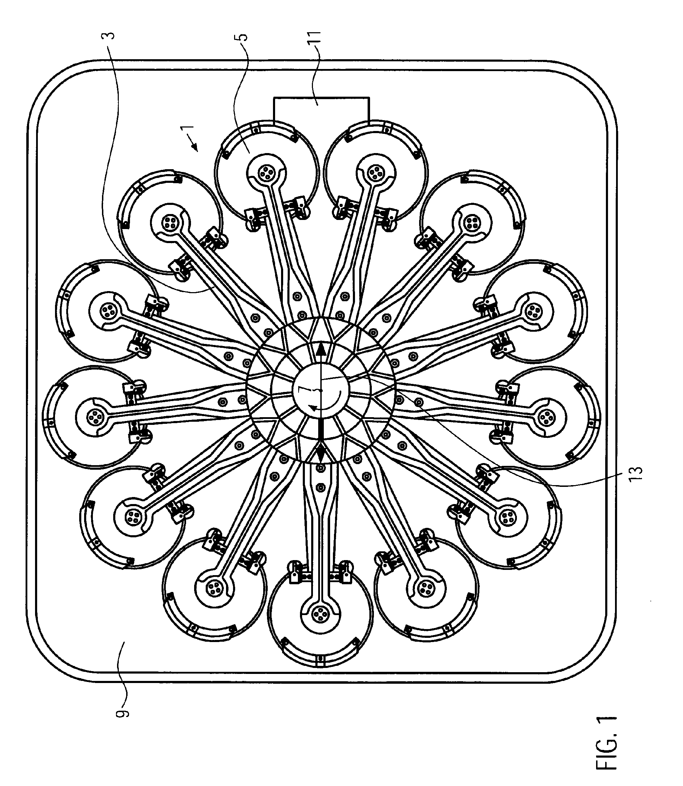

Figure 1 illustrates schematically such an implanter. The device comprises an implantation wheel 1 with a plurality of arms 3 each having at its outside extremity a substrate support 5 on which a substrate to be treated is positioned. The substrates are not visible in Figure 1 as they are positioned on the side of the substrate support 5 which is not visible. The wheel 1 can rotate about its axis 7 in a vertical plane at speeds of about 850 rpm. The implantation wheel 1 is positioned inside a chamber 9 of the ion implanter which also comprises an ion beam generator 11 configured to emit an ion beam, e.g. the said hydrogen and/or helium ions, used to implant into the substrates. The wheel 1 is not only configured to rotate about the axis 7, but it can also be linearly translated in the direction 13 such that the entire surface of a substrate positioned on one of the substrate supports 5 can be implanted.

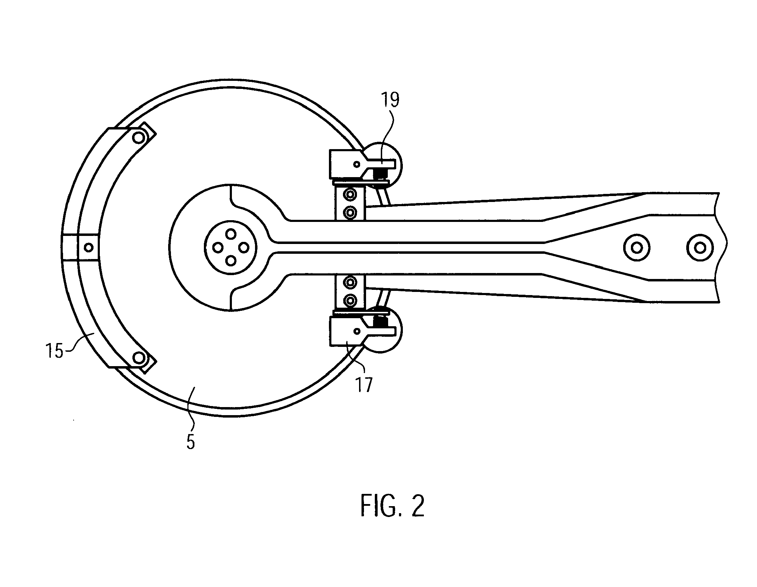

To fix a substrate on the substrate support 5 during rotation and translation, the substrate support 5 comprises a fixed holding means 15 in the edge region of the substrate support 5 on the outer edge of the wheel 1, as illustrated in Figure 2 showing the backside of a substrate holder 5. During rotation, a substrate positioned on the substrate support 5 will be forced against the fixed holding means 15 by the centrifugal force and thereby safely kept in place. To also maintain a substrate on a substrate support 5, when the wheel 1 slows down and comes to a rest, for instance for loading or unloading the wheel, additional clipping means 17 and 19 are provided on the side opposite to the fixed holding means 15. In the Quantum Implanter, the clipping means 17, 19 are configured to engage a substrate on the substrate support 5 when the wheel 1 slows down and comes to a rest, but move away from the substrate when the wheel 1 is rotating with high speed. This is achieved by using a spring and a counterweight which are configured and arranged such that, in the absence of the centrifugal force or below a certain threshold, the force imposed by the spring moves the clipping means 17, 19 back towards the substrate to main the substrate on the holder 5 and, during rotation, the centrifugal force on the counterweight will act against the resilient force of the spring such that the clipping means 17, 19 move away from the substrate.

In the Smart Cut™ process, during which ions are implanted into a semiconductor substrate to form a predetermined splitting area and which is subsequently bonded to a second substrate to transfer the layer defined by the predetermined splitting area, the quality of the implanting step is crucial. However, contamination of the substrates leaving the implanter by small particles is a recurrent problem that is observed and leads to a decrease in uptime of the tools due to the necessary cleaning operations. In an implanter a number of contamination sources have been identified. Amongst others, contamination can occur due to the loading mechanism of the substrates onto the wheel 1, the creation of the ion beam and the rotation of the wheel 1. To ensure final product quality, the production cycle therefore has to be interrupted and the implantation chamber 9 to be opened on a regular basis to clean out the implanter. As any time the tool has to be opened for service, a qualification of the implanter has to be carried out which adds to the downtime of the fabrication line and hence to an increase in overall fabrication costs.

Starting therefrom, it is the object of the present invention to provide a solution which can reduce the contamination by small particles.

This object is achieved with the substrate holder according to claim 1. The substrate holder according to the invention comprises a substrate support, a moveable clipping means configured to engage the substrate on the substrate support in a first position and to be positioned away from the substrate in a second position, a positioning means, in particular a resilient positioning means, for moving the clipping means from the second position towards the first position, and a stopping means, in particular an elastic stop element, for limiting the movement of the clipping means towards the substrate support in the direction defined by the second and first position, such that even in the absence of a substrate on the substrate support, the clipping means remains positioned away from the substrate support.

By providing the stopping means, the particle contamination observed in implanters can be reduced. Even in the absence of a substrate on the substrate support, the stopping means, in particular the elastic element, ensures that no contact between the clipping means and the substrate support can occur. In contrast thereto, in the prior art; a contact occurred between the clipping means and the empty substrate support, when the wheel slowed down, which led to the creation of particles. Actually, the movement of the clipping means towards the substrate holder is ensured by the spring and only limited by the substrate holder itself.

Preferably, the moveable clipping means, the positioning means and the stopping means form one modular unit. By providing a modular unit, existing prior art clipping means together with the positioning means can be easily exchanged so that machines that are already used in the field can be upgraded without major downtime.

Further preferred, the modular unit can comprise a connecting plate for connecting the module unit to the substrate support. This further facilitates the upgrading of already used tools.

According to a preferred embodiment, the support substrate comprises a metallic plate and the clipping means is also metallic. The substrate support should be metallic so that it can act as a heat sink and the clipping means is also out of metal to provide sufficient stiffness when clipping a substrate on the substrate support. The metallic clipping pin on the one hand allows sufficient heat resistance so that; under the impact of the ion beam, the clipping means keeps its shape. On the other hand, no additional qualification process becomes necessary.

Preferably, the elastic stop element can be polyvinylidene fluoride (PVDF) or poly ether ether ketone (PEEK). PVDF and PEEK provide flexibility, light weight and good resistance to chemicals, heat and fire so that their lifetime is sufficiently high to be used in the demanding environment of an ion implanter. PVDF is more economic than PEEK.

According to a preferred embodiment, the substrate holder can comprise a counter-positioning means for moving the clipping means from the first position towards the second position, in particular based on rotational/centrifugal forces. Thus, during implanting, the clipping means is moved away from the substrate so that the entire surface of the substrate can be implanted as shading effects etc, arising due to the vicinity of the clipping means, can be prevented.

The object of the invention is also achieved with the clipping device according to claim 7 and which is suitable for releasably keeping a substrate on a substrate holder according to the embodiments and variants as described above. This clipping device comprises a moveable clipping means, a positioning means for moving, in particular linearly moving, the clipping means and a stopping means, in particular an elastic stop element, for limiting the extent of the positioning movement of the clipping means imposed by the positioning means, at least in one direction. With this device, an unwanted contact between the moveable clipping means and a substrate holder, which could lead to the formation of particles that could contaminate the surface of the substrate which will subsequently be positioned on the substrate holder, can be prevented or at least reduced.

Preferably, the elastic stop element can be a polyvinylidene fluoride which provides flexibility, light weight and good resistance to chemicals, heat and fire so that its lifetime is sufficiently high to be used in the demanding environment of an ion implanter.

Advantageously, the elastic stop element is stationary. By having the elastic stop element on the stationary part of the clipping device, the design of the clipping device is simplified and the weight of the moving parts can be kept minimal.

According to a further preferred embodiment, the clipping means can comprise a pin region and a stop element engagement plate configured and arranged such that the stop element engagement plate comes in contact with the stopping means to stop the movement of the clipping means. Thus, both functions can be achieved with a single workpiece, thus further simplifying the design of the clipping device.

Preferably, the stop element engagement plate can be configured and arranged such that it at least partially masks the elastic stop element. By doing so, the elastic stop element can be protected against the ion beam.

The invention also relates to an ion implanting device comprising a substrate holder and a clipping device as described above.

The invention will be described further in detail based on the enclosed Figures:
- Figure 1: illustrates schematically the implanting wheel of an ion implanter as known in the art,
- Figure 2: illustrates a backside view of a substrate holder used in an ion implanter as known in the art.
- Figures 3a - 3c: schematically illustrate a bottom and top view of a part of a substrate holder and a clipping device according to the invention wherein the corresponding clipping means is in a first position as well as a schematic side cut view,
- Figure 4a - 4c: illustrate schematically a bottom and top view, as well as a side cut view of the substrate holder and a clipping device, when the clipping means is in a second position, and
- Figure 5: illustrates the substrate holder and clipping device according to the invention in the presence of a substrate on the holder.

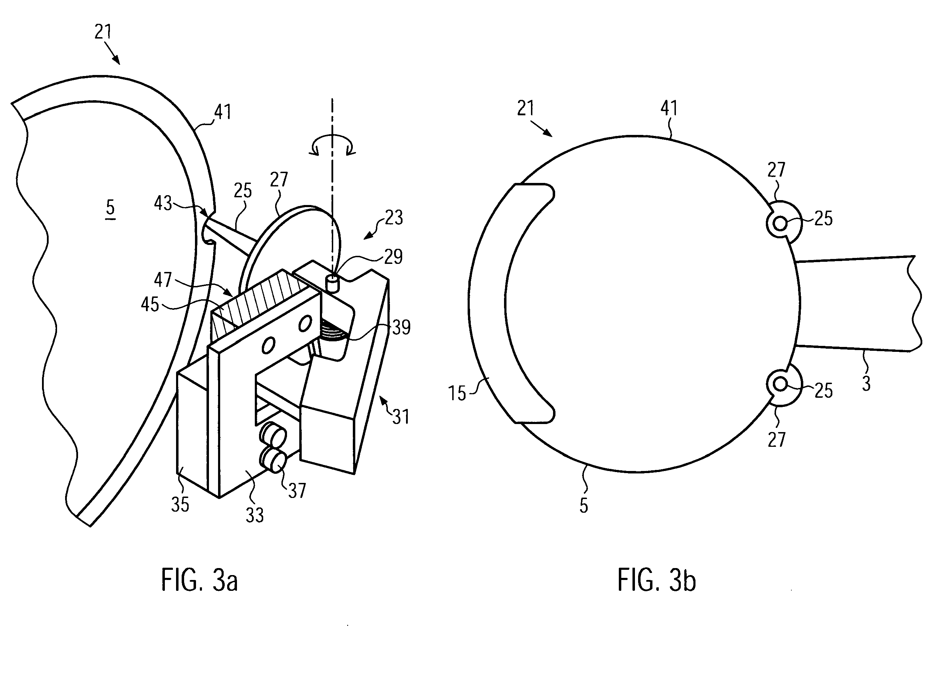

Figure 3a illustrates schematically a partial view of the bottom side of a substrate holder 21 according to the invention. In the illustration, no substrate is positioned on the substrate holder. Features which will be described in the following that carry reference numerals which have already been employed in relation to the ion implanter as illustrated in Figure 1 and the substrate holder as shown in Figure 2, will not be described again in detail, but their description is included herewith by reference.

The substrate holder 21 according to the invention comprises a substrate support 5, typically a circular metallic plate, for instance out of inox, so that it can serve as a heat sink, and a clipping device 23. The clipping device 23 is arranged at the same position like the clipping devices 17 and 19 of the prior art illustrated in Figure 2 with respect to the substrate holder 5.

The clipping device 23 comprises a moveable clipping means with a pin region 25 and a protection plate 27. The pin region 25 and the protection plate 27, in this embodiment, are made out of a single workpiece. Furthermore, a counter body 31, representing the counter positioning means, is integrally formed with the pin region 25 and the protection plate 27. This workpiece is fixed to a pivot 29, defining a rotational axis, with the work piece forming one arm and the pin region and the protection plate 27 forming a second arm.

The pivot 29, materializing the rotational axis, is connected to a connecting plate 33 which serves to connect the clipping device 23 to an attachment area 35 of the substrate holder 21 using bolts 37. The resilient force of a spring 39, which serves as a resilient positioning means and links the pin region 25 with the connecting plate 33, keeps - in the absence of other forces - the pin region 25 in a fixed position close to the edge 41, precisely in an arc-shaped clearance 43 in the edge region of the substrate support 5, but without touching the substrate support 5.

To ensure that no contact exists between the pin region 25 and the edge 41, an elastic stop element 45 acting as stopping means, is attached to the connecting plate 33. In this embodiment, the stop element 45 has a cuboidal shape and is made out of polyvinylidene (PVDF) or poly ether ether ketone (PEEK). The stop element 45 effectively limits the movement of the clipping means (the pin region 25 and the protection plate 27), imposed by the spring 39 as, in this embodiment, the protection plate 27 comes to a rest on the surface 47 of the elastic stop element 45. In that sense, the protection plate 27 serves as a stop element engagement plate.

An elastic material like PVDF is used for the stop element 45 to prevent the creation of small particles when the protection plate 27 comes into contact with the surface 47. PVDF provides flexibility, light weight and good resistance to chemicals, heat and fire. The invention is not limited to the cuboidal shape of the stop element 45, as any shape which allows the protection plate 27 to abut against it, fulfills the inventive function.

The protection plate 27 prevents an exposition of the underlying stop element 45 to the ion beam during ion implantation.

Figure 3b is a top view of the substrate holder 21 which corresponds to the situation illustrated in Figure 3a. It shows the substrate support 5 with the fixed holding means 15 and the arm element 3. The pin regions 25 of the two clipping devices 23 are visible from the top. According to the invention, the elastic stop element 45, in cooperation with the stop element engagement plate 27, ensures that, in the absence of a substrate positioned on the substrate support 5, there is no contact between the pin region 25 and the substrate support 5.

In this view, the elastic stop element 45 is invisible. Indeed, as already mentioned, it is protected against the ion beam by the protection plate 27 also serving as stop element engagement plate.

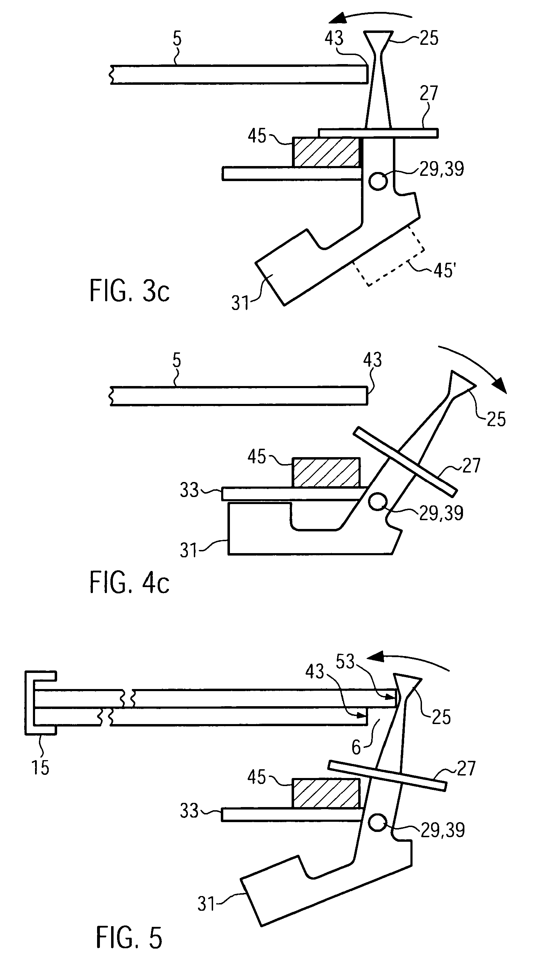

Figure 3c illustrates the same situation in a side cut view. Under the resilient force of the spring 39, acting in the sense of the arrow, the pin region 25 and the counter body 31 rotate around pivot 29 and the stop element engagement plate 27 comes to a rest on the stop element 45 and the counter-body 31 is positioned away from the connecting plate 33. As a consequence, there is no contact between the clearance of the edge 43 of the substrate holder 5 and the pin 25.

In this embodiment, the clipping device 23 with the clipping region 25, the protection plate 27, the positioning means formed by the pivot 29 in combination with spring 39, the counter-body 31 and the stop element 45 are all attached to the connecting plate 33 and thereby form a modular unit.

According to a variant, instead of having the contact between the protection plate 27 and the stop element 45 to limit the movement of the pin region 25, the stop element 45' could be positioned such that the counter body abuts against it under the force of spring 39. This is schematically illustrated in Figure 3c by the dotted lines.

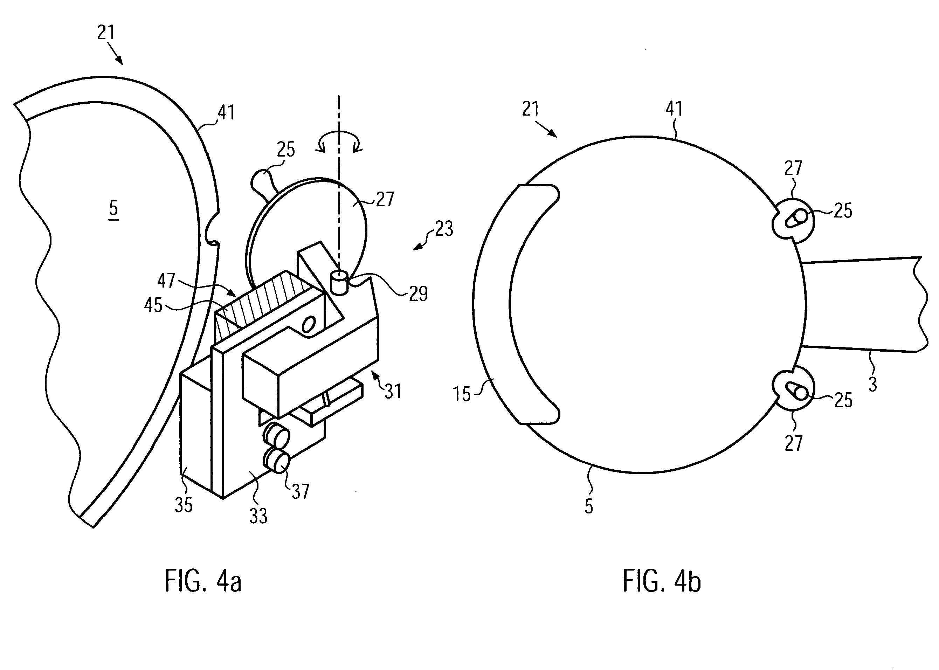

Figure 4a illustrates again a partial view of the substrate holder 21 wherein, however, the pin region 25 is now in a second position further away from the edge 43 of the substrate holder 5. This situation is achieved when the wheel 1 rotates at high speed, e.g. about 850 rpm, such that the rotational force on the counter-body 31, serving as the counter-positional means, acts against the resilient force of the resilient positioning means 39 to provoke a rotation about pivot 29, thereby moving pin 25 away from the position close to the edge 43 of the substrate support 5, as illustrated in Figure 3a. Indeed, due to the rotational force, the counter-body is moved towards the rotational plane. In this embodiment, the movement against the resilient force is furthermore limited to prevent any metal on metal contact between the counter-body 31 and the connecting plate 33. In the configuration as illustrated in Figure 4a, at high speed the counter-body 31 is placed in the rotational plane. The stop element engagement plate 27 (protection plate 27) is no longer in contact with the stop element 45.

The corresponding top view is illustrated in Figure 4b. It shows the substrate holder 5 with the fixed holding means 15, the arm region 3 and the moveable clipping means 25 now moved further away from the edge 41 of the substrate support 5 than in Figure 3b.

Figure 4c illustrates the same situation in the side cut view. In the second position, the stop element engagement plate 27 is no longer in touch with the stop element 45.

By the way, at the moment of charging or loading a substrate on the substrate holder 5, a clip actuator forces the counter-body 31 in essentially the same position as illustrated in Figures 4a to 4c to remove the clipping pin 25 from the edge 41 of the substrate support to facilitate the removal or loading when the wheel is at rest.

Figure 5 illustrates in a schematic side cut view, the situation when a substrate 51 is positioned on the substrate holder 5, when the wheel 1 is on rest. In the area of the clearance 43 in the edge 41 of the substrate holder 5 the substrate 51 laterally extends beyond the edge 41 of the substrate support 5. Due to the resilient force (see arrow) of spring 39, the pin region 25 is held in contact with the edge 53 of the substrate 51 to clamp the substrate 51 onto the substrate holder 5 by actually pushing it against the fixed holding means 15. Here, thus the pin region 25 touches the edge 55 of substrate 51 which prevents the spring 39 to force the stop element engagement plate 27 against the surface 47 of stop element 45. Thus, in the substrate engagement position, the pin region 25 is in an intermediate position between the position illustrated in Figure 3c and the one illustrated in Figure 4c.

With the inventive substrate holder 21 comprising the inventive clipping device 23 which can for instance be used in an ion implanting device, as illustrated in Figure 1, it is ensured that, at all times, the pin region 25 does not touch the substrate support 5 in the absence of a substrate positioned on one of the substrate holders 5 of a wheel 1. By doing so, a particle creation which arises in the prior art due to a metal/metal contact in the vicinity of the substrates, can be prevented or at least reduced.

By providing a modular unit, already used clipping devices which do not have the stop element 41 can be replaced without having to change the design of the machine.

## Claims

1. Substrate holder comprising:
- a substrate support (5),
- a moveable clipping means (25) configured to engage a substrate (51) on the substrate support (5) in a first position and to be positioned away from the substrate in a second position,
- a positioning means (39), in particular a resilient positioning means, for moving the clipping means (25) from the second position to the first position, and
- a stopping means, in particular an elastic stop element (45), for limiting the movement of the clipping means (25) towards the substrate support in the direction defined by the second and first position, such that even in the absence of a substrate on the substrate support (5), the clipping means (25) remains positioned away from the substrate support (5).

2. Substrate holder according to claim 1, wherein the moveable clipping means (25), the positioning means (39) and the stopping means (41) form one modular unit.

3. Substrate holder according to claim 2, wherein the modular unit comprises a connecting plate (33) for connecting the module unit to the substrate support (5).

4. Substrate holder according one of claims 1 to 3, wherein the substrate support (5) comprises a metallic plate and wherein the clipping means (25) is also metallic.

5. Substrate holder according to one of claims 1 to 4, wherein the elastic stop element (45) is of Polyvinylidene fluoride (PVDF) or poly ether ether ketone (PEEK).

6. Substrate holder according to one of claims 1 to 5, further comprising a counter positioning means (31) for moving the clipping means (25) from the first to the second position, in particular based on rotational forces.

7. Clipping device for releasably keeping a substrate on a substrate holder according to one of claims 1 to 6, comprising:
- a moveable clipping means (25),
- a positioning means (39) for moving, in particular linearly moving, the clipping means, and
- a stopping means, in particular an elastic stop element (45), for limiting the extent of the positioning movement of the clipping means (25) imposed by the positioning means (39) at least in one direction.

8. Clipping device according to claim 7, wherein the elastic stop element (45) is of polyvinylidene fluoride (PVDF) or poly ether ether ketone (PEEK).

9. Clipping device according to claim 7 or 8, wherein the elastic stop element (45) is stationary.

10. Clipping device according to claim 7 or 8, wherein the clipping means comprises a pin region (25) and a stop element engagement plate (27) configured and arranged such that the stop element engagement plate (27) comes into contact with the stopping means (41) to thereby stop the movement of the clipping means (25).

11. Clipping device according to claim 10, wherein the stop element engagement plate (27) is configured and arranged such that it at least partially masks the elastic stop element (45).

12. Ion implanting device comprising a substrate holder according to one of claims 1 to 6 and a Clipping device according to one of claims 7 to 11.
